# EUROPEAN PATENT APPLICATION

(11) **EP 4 734 731 A1**
(43) Date of publication of application: **29.04.2026**
(21) Application number: 24825780.0
(22) Date of filing: 10.06.2024
(51) Int. Cl.: H10N 10/852, H10N 10/01, H10N 10/817

(54) **METHOD FOR PRODUCING THERMOELECTRIC CONVERSION ELEMENT AND THERMOELECTRIC CONVERSION ELEMENT**

(30) Priority: 23.06.2023 JP 2023102937
(71) Applicant: National Institute for Materials Science, Tsukuba-shi, Ibaraki 305-0047 (JP)
(72) Inventor: MORI, Takao, Tsukuba-shi, Ibaraki 305-0047 (JP); CHETTY, Raju, Tsukuba-shi, Ibaraki 305-0047 (JP)
(74) Representative: Plougmann Vingtoft a/s
(86) International application number: PCT/JP2024/021054
(87) International publication number: WO 2024/262375

(57) **Abstract**

A thermoelectric conversion element according to the present invention is made by laminating an electrode material that contains an alloy of copper (Cu) and nickel (Ni) on a thermoelectric conversion layer consisting of a thermoelectric conversion material which contains magnesium (Mg) and antimony (Sb). The production method of the present invention is a method for manufacturing a thermoelectric conversion element which has a thermoelectric conversion layer and an electrode layer laminated to the thermoelectric conversion layer, the method including: a first sintering process for sintering a thermoelectric conversion material to form a pellet; a laminating process for forming a layer of electrode material on the pellet; and a second sintering process for heat treating the pellet on which the layer of electrode material has been formed, wherein the first sintering process is performed at a temperature higher than the reaction initiation temperature at which the electrode material starts to react with the thermoelectric conversion material, and the second sintering process is performed at a temperature lower than the reaction initiation temperature. In magnesium antimony (MgSb)-based thermoelectric conversion element, both low contact resistance and affinity with solder can be achieved.

## Description

### Technical Field

The present invention relates to a method for manufacturing a thermoelectric conversion element and a thermoelectric conversion element, and it is particularly suitable for use in a thermoelectric conversion element that ensures reliable electrical connection with circuit wiring.

### Background Art

As research on the efficient use of energy, including energy conservation and the use of renewable energy, is being promoted, thermoelectric elements are attracting attention as devices that enable the direct conversion of waste thermal energy into electrical energy for reuse.

A thermoelectric conversion material has been developed having reduced thermal conductivity and increased charge mobility by adding copper (Cu) to n-type magnesium antimony (Mg₃Sb₂) materials (see NPL 1). The thermoelectric conversion material needs be connected to the circuit wiring in order to extract the converted electrical energy.

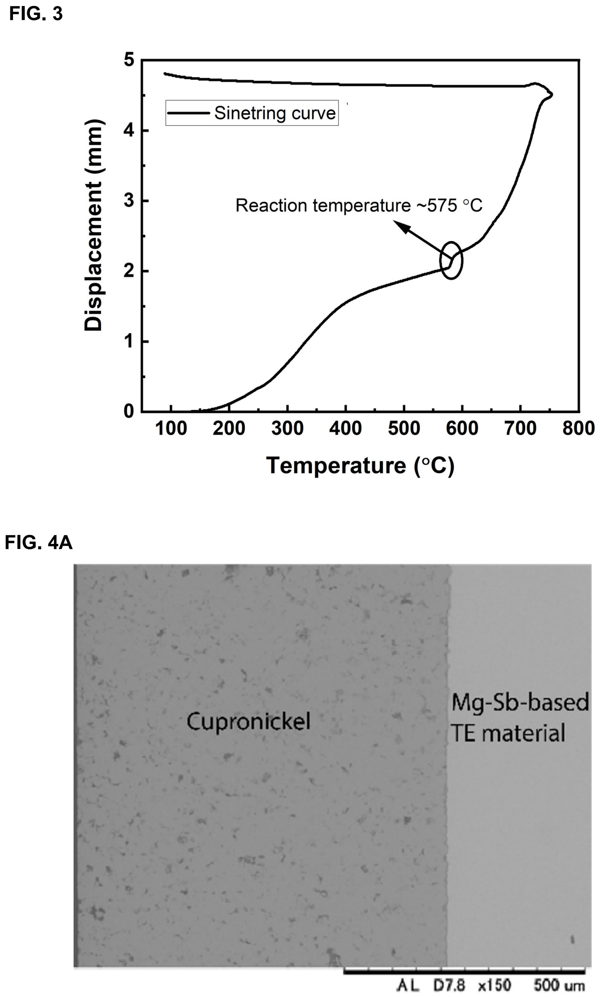

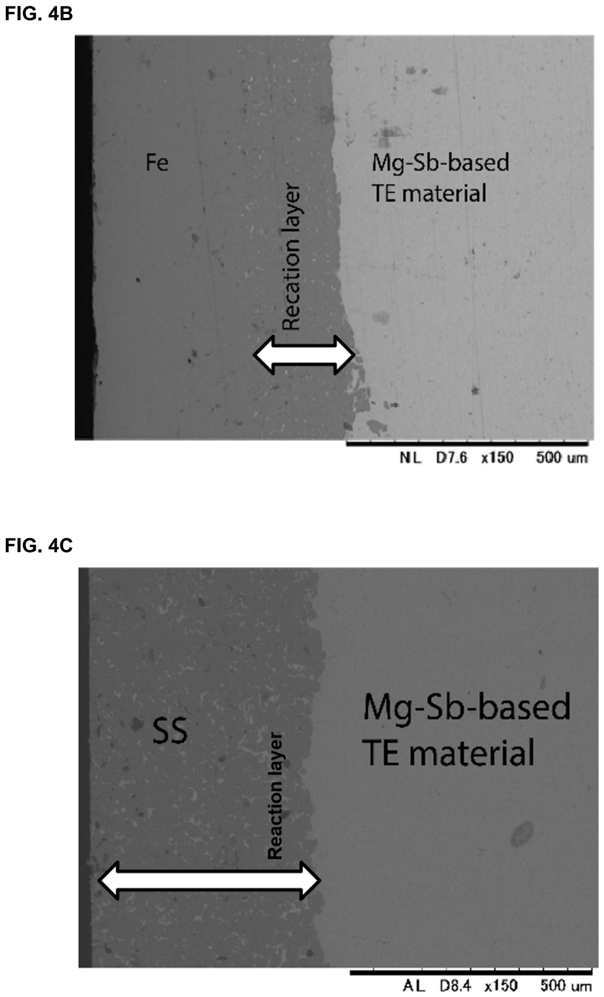

NPL 2 reports that iron magnesium chromium (Fe₇Mg₂Cr), which is an Fe-based ternary alloy, and iron magnesium titanium (Fe₇Mg₂Ti) are suitable interface materials to be laminated on the thermoelectric conversion layer of n-type magnesium antimony bismuth (Mg₃Sb_{1.5}Bi_{0.5}). According to FIG. 4 of NPL 2, when these materials are used as an interface layer, shear strength of 30 MPa or higher can be achieved while keeping the specific contact resistivity below 10 µΩ cm².

PTL 1 discloses a technique for reducing electrical resistance in thermoelectric conversion elements using magnesium antimony bismuth esterl (MgSbBiTe)-based thermoelectric conversion materials. When electrode layers made of an alloy of copper (Cu) and zinc (Zn) are formed on both ends of a thermoelectric conversion layer, which is a MgSbBiTe-based sintered body, using a spark plasma sintering device, an intermediate layer is formed between the thermoelectric conversion layer and the electrode layer. PTL 1 describes that a thermoelectric conversion element with significantly lower resistivity than a comparative example, in which nickel (Ni) electrode layers were formed on both ends of the thermoelectric conversion layer, which is a MgSbBiTe-based sintered body, by electrolytic plating, has been realized.

In the invention disclosed in PTL 2, in a thermoelectric conversion element using MgSbBiTe thermoelectric conversion material, transitional layers and electrode layers are formed on both ends of a thermoelectric conversion layer. It is described that the transition layer is an alloy of copper (Cu) and titanium (Ti) and/or magnesium (Mg), and the electrode layer is Cu and/or Ni. It is described that in each Example, a temperature difference of 50 ° C or more was reportedly measured when 12 V was applied.

In the invention disclosed in PTL 3, it is described that a compound expressed as the chemical formula FeₓMg_{y}A_{z} (where A is a transition metal, x = 3-10, y = 1-5, z = 1-3) is suitable as an interface layer material for a thermoelectric conversion element using a Mg₃Sb₂-based conversion material, and that low contact resistance of 5 to 10 µΩ cm² or less has been measured.

### CITATION LIST

### Patent Document

PTL 1: U.S. Patent Application Publication US2020/0006616
PTL 2: International Publication WO2021/036544
PTL 3: China Patent Publication CN115020577A

### Non-Patent Document

NPL 1: Z. Liu, et al, "Demonstration of Ultrahigh Thermoelectric Efficiency of ~7.3% in Mg3Sb2/MgAgSb Module for Low Temperature Energy Harvesting", Joule 5, May 19, 2021, pp. 1196-1208.
NPL 2: X. Wu, et al, "A general design strategy for thermoelectric interface materials in n-type Mg3Sb1.5Bi0.5 single leg used in TEGs", Acta Materialia, 226 (2022) 117616.

### SUMMARY OF THE INVENTION

### Problems to be Solved by the Invention

The present inventors' review of PTLs 1, 2, 3 and NPLS 1, 2 revealed the following new problems.

As shown in NPL 2 and PTL 3, contact resistance lower than 10 µΩ cm² can be achieved in a MgSb-based thermoelectric conversion layer by providing an iron-based alloy in the interface layer. However, since iron-based alloys have low affinity with solder, there is a problem that it is difficult to form stable, low-resistance and highly reliable connections with circuit wiring. In this specification, affinity with solder means ease of soldering, and more specifically, molten solder has high wettability and wet solder is easy to diffuse.

On the other hand, the interface layers of the thermoelectric conversion elements shown in PTLs 1 and 2 have high affinity with solder, so it is expected that they could form a stable, low-resistance and highly reliable connection between the circuit wiring. The thermoelectric conversion element described in PTL 1 has a CuZn alloy electrode layer formed on both ends of the thermoelectric conversion layer via a CuZnMg intermediate layer. The thermoelectric conversion element described in PTL 2 has transitional layers of Cu and Ti and/or Mg-alloy and Cu and/or Ni electrode layers on both ends of the thermoelectric conversion layer.

The present inventors, however, have found that the materials of the interface layer disclosed in PTLs 1 and 2 have a problem that the contact resistance with the thermoelectric conversion layer is high. PTL 1 reports resistance values of 16.4 m Ω and 7.05 m Ω and resistivity of 50.2 µΩ m and 21.6 µΩ m in two Examples, but does not report the contact resistance. The contact resistance of the interface between the electrode layer made of various materials and the MgSb-based thermoelectric conversion layer is reported in the above-mentioned NPL 2. FIG. 4 of NPL 2 reports that the contact resistance when Cu is used as the material of the interface layer is approximately 80 Ω cm². It was found that the electrode layer consisting mainly of Cu, which has a high affinity with solder, does not provide sufficiently low contact resistance between the thermoelectric conversion layers.

Through these studies, the present inventors have found a new challenge to achieve both low contact resistance below 10 µΩ cm² and affinity with solder.

An object of the present invention is to achieve both low contact resistance and affinity with solder in a MgSb-based thermoelectric conversion element: one of the objects is to provide a production method capable of solving this problem, and another is to identify an electrode material capable of solving this problem.

### Means for Solving Problems

According to an embodiment, as follows.

That is, a method for manufacturing a thermoelectric conversion element having a thermoelectric conversion layer and an electrode layer laminated on the thermoelectric conversion layer, the method comprising: a first sintering process for sintering a thermoelectric conversion material to form a pellet; a laminating process for forming a layer of electrode material on at least one of the two opposing sides of the pellet; and a second sintering process for heat treating the pellet on which the layer of electrode material has been formed, wherein the first sintering process is performed at a temperature higher than the reaction initiation temperature at which the electrode material starts to react with the thermoelectric conversion material, and the second sintering process is performed at a temperature lower than the reaction initiation temperature.

According to another embodiment, as follows.

A thermoelectric conversion element having a thermoelectric conversion layer and first and second electrode layers with the thermoelectric conversion layer laminated therebetween, in which the thermoelectric conversion layer consists of a thermoelectric conversion material containing magnesium (Mg) and antimony (Sb); and the first and second electrode layers consist of an electrode material containing an alloy of copper (Cu) and nickel (Ni).

### Effect of the Invention

The effect to be produced by the above-described embodiment will be briefly described below.

In other words, in a MgSb-based thermoelectric conversion element, both low contact resistance and affinity with solder can be achieved.

### BRIEF DESCRIPTION OF THE DRAWINGS

FIG. 1 is an explanatory drawing showing an example configuration of a thermoelectric conversion element of the present invention.
FIG. 2 is a flowchart showing an example of a method for manufacturing a thermoelectric conversion element of the present invention.
FIG. 3 is a graph showing a sintering curve as an experimental result.
FIG. 4a is a cross-sectional scanning electron microscope (SEM) image showing an interface between a MgSb-based thermoelectric conversion layer and a cupronickel electrode layer.
FIG. 4b is a cross-sectional SEM image showing an interface between a MgSb-based thermoelectric conversion layer and a Fe electrode layer.
FIG. 4C is a cross-sectional SEM image showing an interface between a MgSb-based thermoelectric conversion layer and a stainless steel electrode layer.
FIG. 5 is a graph showing measurement results of contact resistance of electrodes in a thermoelectric conversion element prototyped as an example.
FIG. 6 is a graph showing measurement results of thermoelectric conversion efficiency in a thermoelectric conversion element prototyped as an example.

### DETAILED DESCRIPTION OF THE INVENTION

### 1. Overview of Embodiment

First, an overview of a representative embodiment disclosed in the present application will be given. Reference codes in the drawings that are referred to in parentheses in the outline description of representative embodiment are merely illustrative of what is included in the concept of the components to which they refer.

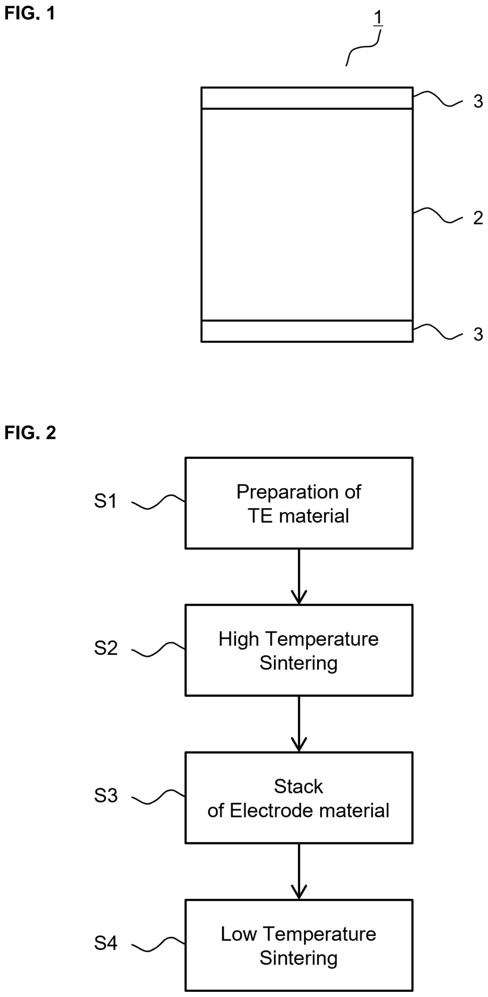

### [1] Thermoelectric conversion element with MgSb-based thermoelectric conversion layer and CuNi alloy electrode layer (FIG. 1)

A typical embodiment disclosed in this application is a thermoelectric conversion element (1) which has a thermoelectric conversion layer (2) and an electrode layer (3) laminated on the thermoelectric conversion layer, and is configured as follows.

The thermoelectric conversion layer consists of a thermoelectric conversion material containing Mg and Sb, and the electrode layer consists of an electrode material containing an alloy of Cu and Ni.

This allows both low contact resistance and affinity with solder in a MgSb-based thermoelectric conversion element. The Cu-Ni alloy (cupronickel) can form a low-resistance ohmic contact with the MgSb-based thermoelectric conversion layer, and has high solder affinity.

### [2] Case where thermoelectric conversion material is MgSbBi

The thermoelectric conversion element according to [1], in which the thermoelectric conversion material further contains bismuth (Bi) and is expressed as Mg₃₊ᵥSb_{w}Biₓ (where 0.1 < v < 0.3, 1.35 < w < 1.65, 0.45 < x < 0.55).

This allows both low contact resistance and affinity with solder to be achieved even when the thermoelectric conversion material is MgSbBi, i.e., an Sb-rich MgSb-based thermoelectric conversion element. However, this does not exclude a Bi-rich case (where 2.7 < v < 3.3, 0.45 < w < 0.55, 1.35 < x < 1.65). In addition, by making Mg excessive as in this [2], the thermoelectric conversion element can be made to behave as an n-type.

### [3] Case where thermoelectric conversion material is MgSbBTe

The thermoelectric conversion element according to [1], in which the thermoelectric conversion material further contains Bi and tellurium (Te) and is expressed as Mg₃₊ᵥSb_{w}BiₓTe_{y} (where 0.1 < v < 0.3, 1.35 < w < 1.65, 0.44 < x < 0.54, 0.001 < y < 0.011).

This allows both low contact resistance and affinity with solder, even when the thermoelectric conversion material is MgSbBiTe.

### [4] Case where thermoelectric conversion material is MgSbBiTeCu

The thermoelectric conversion element according to [1], in which the thermoelectric conversion material further contains Bi, Te and Cu and is expressed as Mg₃₊ᵥSb_{w}BiₓTe_{y}Cu_{z} (where 0.1 < v < 0.3, 1.35 < w < 1.65, 0.43 < x < 0.53, 0.001 < y < 0.011, 0.009 < z < 0.011).

This allows both low contact resistance and affinity with solder, even when the thermoelectric conversion material is MgSbBiTeCu.

### [5] Method for manufacturing thermoelectric conversion element including two-step sintering process (FIG. 2)

A typical embodiment disclosed in this application is a method for manufacturing a thermoelectric conversion element which has a thermoelectric conversion layer and an electrode layer laminated to the thermoelectric conversion layer, and is configured to include the following processes.

First sintering process (S2): sintering a thermoelectric conversion material to form a pellet.

Laminating process (S3): laminating an electrode material on at least one of the two opposing sides of the pellet.

Second sintering process (S4): heat treating the pellet on which the layer of electrode material has been formed.

Here, the first sintering process is performed at a temperature higher than the reaction initiation temperature at which the electrode material starts to react with the thermoelectric conversion material, and the second sintering process is performed at a temperature lower than the reaction initiation temperature.

This allows the production of a thermoelectric conversion element that has both low contact resistance and affinity with solder. This is because a material with high affinity with solder is selected for the electrode layer, and the sintering temperature at which a low-resistance ohmic contact can be formed with the thermoelectric conversion layer can be determined independently of the optimum temperature for sintering the thermoelectric conversion layer. Note that the thermoelectric conversion material of the present invention is not limited to MgSb-based materials. For any thermoelectric conversion material, a material with high affinity with solder can be selected for the electrode layer, and the optimum sintering temperature can be set for each.

### [6] Second sintering process is performed below temperature at which CuNi alloy begins to react with MgSb-based thermoelectric conversion material

The method for manufacturing a thermoelectric conversion element according to claim [5], in which the thermoelectric conversion material contains Mg and Sb, and the electrode material contains a CuNi alloy; and the reaction initiation temperature is the temperature at which the reaction between the thermoelectric conversion material and Cu and/or Ni begins.

This allows the electrode layer of Cu-Ni alloy (cupronickel) to have affinity with solder and to form a low-resistance ohmic contact with the MgSb-based thermoelectric conversion layer, so that in a MgSb-based thermoelectric conversion element, both low contact resistance and affinity with solder can be achieved.

### [7] Case where thermoelectric conversion material is MgSbBiTeCu

The method for manufacturing a thermoelectric conversion element according to claim [6], in which the thermoelectric conversion material is Mg₃₊ᵥSb_{w}BiₓTe_{y}Cu_{z} (where 0.1 < v < 0.3, 1.35 < w < 1.65, 0.43 < x < 0.53, 0.001 < y < 0.011, 0.009 < z < 0.011).

This makes it possible to produce a MgSb-based thermoelectric conversion element that have both low contact resistance and affinity with solder, even when the thermoelectric conversion material is MgSbBiTeCu.

### 2. Details of the embodiments

The embodiments will now be described in further detail.

### [Embodiment 1]

FIG. 1 is an explanatory drawing showing an example configuration of thermoelectric conversion element 1 of the present invention. Thermoelectric conversion element 1 is a thermoelectric conversion element provided with a MgSb-based thermoelectric conversion layer and a CuNi alloy electrode layer.

That is, thermoelectric conversion element 1 has thermoelectric conversion layer 2 and electrode layer 3 laminated to thermoelectric conversion layer 2, thermoelectric conversion layer 2 consisting of a thermoelectric conversion material containing Mg and Sb, and electrode layer 3 consisting of an electrode material containing an alloy of Cu and Ni. Electrode layers 3 may be formed by laminating thermoelectric conversion layer 2 sintered and molded in a pellet shape, for example, so as to sandwich thermoelectric conversion layer 2 from above and below.

This allows both low contact resistance and affinity with solder in a MgSb-based thermoelectric conversion element. The Cu-Ni alloy (cupronickel) can form a low-resistance ohmic contact with the MgSb-based thermoelectric conversion layer, and has high solder affinity. If there is only one surface to be soldered to the circuit wiring, the cupronickel electrode layer 3 may be formed only on that surface, and the other surface may be electrically connected in a different manner.

Thermoelectric conversion layer 2 may further be a thermoelectric conversion material containing bismuth (Bi) in addition to Mg and Sb and expressed as Mg₃₊ᵥSb_{w}Biₓ (however, 0.1 < v < 0.3, 1.35 < w < 1.65, 0.45 < x < 0.55), and further may be a thermoelectric conversion material containing tellurium (Te) and expressed as Mg_{3+ v}Sb_{w}BiₓTe_{y} (0.1 < v < 0.3, 1.35 < w < 1.65, 0.44 < x < 0.54, 0.001 < y < 0.011). Here, the behavior of the thermoelectric conversion layer can be adjusted to n-type by excessively increasing the composition of Mg from a stoichiometric ratio of 3 to, for example, 3.1 to 3.3.

It is more preferable that thermoelectric conversion layer 2 contains Bi, Te and Cu in addition to Mg and Sb, and is made of a thermoelectric conversion material expressed as Mg₃₊ᵥSb_{w}BiₓTe_{y}Cu_{z} (where 0.1 < v < 0.3, 1.35 < w < 1.65, 0.43 < x < 0.53, 0.001 < y < 0.011, 0.009 < z < 0.011).

### [Embodiment 2]

FIG. 2 is a flowchart showing an example of a method for manufacturing a thermoelectric conversion element of the present invention. The production method of the present invention is a method for manufacturing a thermoelectric conversion element which has a thermoelectric conversion layer and an electrode layer laminated to the thermoelectric conversion layer, and is configured to include the following processes. The thermoelectric conversion layer is not limited to the Mg- and Sb-containing thermoelectric conversion materials illustrated in Embodiment 1.

Preparation process (S1): Prepare a thermoelectric conversion material. The substances that make up the thermoelectric conversion material are prepared in accordance with the desired stoichiometric ratio. The prepared material substances are mixed and processed into powder using a grinder.

First sintering process (S2): the prepared thermoelectric conversion material is contained in, for example, a graphite crucible, and sintered at high pressure and high temperature to form a pellet. The pellet is, for example, cylindrical.

Laminating process (S3): a layer of electrode material is formed on the pellet. For example, the pellet is sandwiched from above and below with powdered electrode materials and put into a graphite crucible, thereby laminating the electrode materials on the pellet.

Second sintering process (S4): the pellet on which the electrode material is laminated is heat treated.

Here, the first sintering process (S2) is performed at a temperature higher than the reaction initiation temperature at which the electrode material starts to react with the thermoelectric conversion material, and the second sintering process (S4) is performed at a temperature lower than the reaction initiation temperature.

This allows the production of a thermoelectric conversion element that has both low contact resistance and affinity with solder. This is because a material with high affinity with solder is selected for the electrode layer, and the sintering temperature at which a low-resistance ohmic contact can be formed with the thermoelectric conversion layer can be determined independently of the optimum temperature for sintering the thermoelectric conversion layer.

It is suitable when the thermoelectric conversion layer is formed of a MgSb-based thermoelectric conversion material and a cupronickel (Cu-Ni alloy) electrode material is laminated thereon. The reaction initiation temperature is set to the temperature at which the reaction between the MgSb-based thermoelectric conversion material and cupronickel begins. The cupronickel electrode layer is not only capable of forming a low-resistance ohmic contact with the MgSb-based thermoelectric conversion layer, but also has an affinity with solder and is easy to solder to external circuit wiring, so that in a MgSb-based thermoelectric conversion element, both low contact resistance and affinity with solder can be achieved.

The reaction initiation temperature may be determined, for example, by referring to the sintering curve. FIG. 3 is a graph showing a sintering curve as an experimental result. Temperature is plotted on the horizontal axis and displacement of the sample is plotted on the vertical axis.

When the temperature is gradually increased from room temperature, an inflection point is observed at approximately 575 ° C, where the change in displacement per unit temperature change suddenly becomes large. It is believed that this temperature is the starting temperature at which the reaction between cupronickel (Cu-Ni alloy), the electrode material, and the MgSb-based thermoelectric conversion material begins. When the temperature is further increased, the original slope is restored at approximately 585°C, and the slope gradually increases until the cupronickel melts when the temperature exceeds approximately 750°C. Even if the temperature is then lowered, the displacement does not return to the original value.

When the thermoelectric conversion layer is formed of a MgSb-based thermoelectric conversion material, a sintering temperature of approximately 750°C is suitable; however, from the sintering curve above, it can be seen that if the electrode material contains Cu, a reaction with the thermoelectric conversion material may begin and even melt.

In the production method of Embodiment 2, in the example of the MgSb-based thermoelectric conversion material and the cupronickel (Cu-Ni alloy) electrode material described above, it is found desirable that the sintering temperature in the first sintering process (S2) should be set to 750°C because the thermoelectric conversion layer is sintered, and the sintering temperature in the second sintering process (S4) should be kept below 575°C, the reaction initiation temperature, because this process mainly sinters the electrode layer.

As described above, the MgSb-based thermoelectric conversion material is preferably Mg₃₊ᵥSb_{w}BiₓTe_{y}Cu_{z} (where 0.1 < v < 0.3, 1.35 < w < 1.65, 0.43 < x < 0.53, 0.001 < y < 0.011, 0.009 < z < 0.011) and a cupronickel (Cu-Ni alloy) electrode material. This makes it possible to produce a MgSb-based thermoelectric conversion element that have both low contact resistance and affinity with solder, even when the thermoelectric conversion material is MgSbBiTeCu.

The present invention will now be described in detail with reference to specific examples, but it should be noted that the present invention is not limited to these examples.

### [Examples]

### <Example 1>

As an example of the present invention, the present inventors fabricated a prototype thermoelectric conversion element in which electrode layers of Cu₇₀Ni₃₀ are laminated on both sides of a thermoelectric conversion layer of Mg_{3.2}Sb_{1.5}Bi_{0.49}Te_{0.01}Cu_{0.01}, and obtained the following results: contact resistance of 5.1 µΩ cm², conversion efficiency of 8% at a temperature difference of 273 K, and maximum output power density of 0.94 Wcm⁻² at a temperature difference of 273 K.

### Prototype Method

Preparation process (S1): Mg (99.95%, Sigma-Aldrich), Sb (99.999%, 5N plus), Bi (99.999%, 5N plus), Te (99.999%, 5N plus), and Cu (99.9995%, Sigma-Aldrich) were weighed out according to the specified stoichiometric ratio. The prepared materials were milled for 5 hours using a SPEX SamplePrep ball mill 8000D, mixed, and processed into a powder.

First sintering process (S2): The powdered material was filled into a graphite crucible with a diameter of 10 mm, and the sample was heated at 100 K/min using a spark plasma sintering device SPS-1080 produced by SPS SYNTEX, and sintered for 5 minutes at a temperature of 1023 K and a pressure of 60 MPa. The thickness of the obtained sintered body was approximately 2.9 mm.

Lamination process (S3) and second sintering process (S4): The obtained sintered body was sandwiched between cupronickel powder (99.9%, produced by Nilaco), and the sample was heated at 100 K/min using the same SPS SYNTEX spark plasma sintering device SPS-1080, and sintered for 10 minutes at a temperature of 773 K and a pressure of 60 MPa. The thickness of the obtained sintered body was approximately 4.4 mm, which was the original thickness of 2.9 mm plus 0.75 mm on each of the front and back sides.

As comparative examples, a sample (Comparative Example 1) in which an electrode layer of Fe was laminated on a thermoelectric conversion layer of Mg_{3.2}Sb_{1.5}Bi_{0.49}Te_{0.01}Cu_{0.01}, and a sample (Comparative Example 2) in which an electrode layer of stainless steel was laminated on a thermoelectric conversion layer of Mg_{3.2}Sb_{1.5}Bi_{0.49}Te_{0.01}Cu_{0.01} were produced.

### [Measurement results]

First, the cross sections of the prototype samples and prototype examples 1 and 2 were observed using a scanning electron microscope (SEM).

FIGS. 4a, 4b, and 4c are cross-sectional SEM images showing the interface between the thermoelectric conversion layer and the cupronickel electrode layer, the interface between the thermoelectric conversion layer and Fe electrode layer, and the interface between the thermoelectric conversion layer and the stainless steel electrode layer, respectively. In Comparative Example 1 (FIG. 4B), a layer in which it is recognized that there has been a reaction between Fe and the MgSb-based thermoelectric conversion layer (shown as "Reaction layer" in FIG. 4B) was observed. In Comparative Example 2 (FIG. 4C), a layer in which it is recognized that there has been a reaction between stainless steel and the MgSb-based thermoelectric conversion layer (shown as "Reaction layer" in FIG. 4C) was observed. On the contrary, in this example sample (FIG. 4a), no reaction between the electrode material and the thermoelectric conversion layer was observed, indicating that a steep interface was formed.

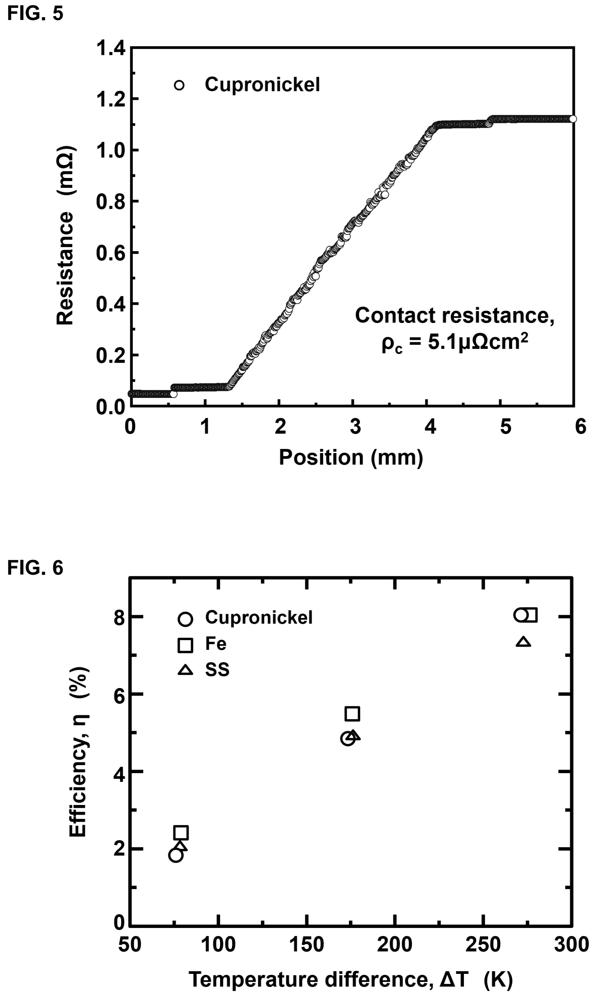

FIG. 5 is a graph showing measurement results of contact resistance of electrodes in a thermoelectric conversion element prototyped. A rectangular parallelepiped with a cross section of 2.90 mm x 2.94 mm x length of 4.4 mm was cut out from the prototype thermoelectric conversion element (diameter 10 mm, thickness 4.4 mm), electrodes were placed in contact with both ends where the cupronickel electrode layers were formed, current was passed through the electrodes, and the potential appearing on a probe in contact with the side (corresponding to the cross section of the prototype thermoelectric conversion element) was measured while moving the probe. The position of the probe is plotted on the horizontal axis and the measured resistance (the measured potential divided by the current value passed) is plotted on the vertical axis.

The contact resistance was measured to be 0.06 m Ω. Multiplying this by the cross-sectional area (0.290 cm x 0.294 cm) gave a contact resistance of 5.1 µΩ cm².

FIG. 6 is a graph showing measurement results of thermoelectric conversion efficiency in a thermoelectric conversion element prototyped. The temperature difference is plotted on the horizontal axis and the thermoelectric conversion efficiency is plotted on the vertical axis. The thermoelectric conversion efficiency was measured to be 1.8% at a temperature difference of 75 K, 4.9% at a temperature difference of 173 K, and 8.0% at a temperature difference of 273 K. For comparison, samples (Comparative Examples 1 and 2) in which the electrode layer material was Fe and stainless steel were prepared and measured, and the same thermoelectric conversion efficiency was measured.

As described above, by using cupronickel as the electrode layer in the MgSb-based thermoelectric conversion element, while employing a Cu-based electrode material that is easy to solder, a conversion efficiency comparable to or higher than that of thermoelectric conversion elements using Fe, stainless steel, FeCrTiMnMg, etc. as an interface layer, which have been reported in many papers, was obtained. This result shows that cupronickel and similar alloys have extremely excellent capabilities as interface materials for extracting electricity from MgSb-based thermoelectric conversion materials.

The present invention made by the present inventors has been specifically described above based on the embodiments, but obviously, the present invention is not limited thereto and can be modified in various ways without departing from the spirit of the present invention.

### EXPLANATION OF SIGN

1 Thermoelectric conversion element
2 Thermoelectric conversion layer
3 Electrode layer

## Claims

1. A thermoelectric conversion element having a thermoelectric conversion layer and an electrode layer laminated on the thermoelectric conversion layer, wherein:
the thermoelectric conversion layer consists of a thermoelectric conversion material containing magnesium (Mg) and antimony (Sb); and
the electrode layer consists of an electrode material containing an alloy of copper (Cu) and nickel (Ni).

2. The thermoelectric conversion element according to claim 1, wherein
the thermoelectric conversion material further contains bismuth (Bi) and is expressed as Mg₃₊ᵥSb_{w}Biₓ (where 0.1 < v < 0.3, 1.35 < w < 1.65, 0.45 < x < 0.55).

3. The thermoelectric conversion element according to claim 1, wherein
the thermoelectric conversion material further contains Bi and tellurium (Te) and is expressed as Mg₃₊ᵥSb_{w}BiₓTe_{y} (where 0.1 < v < 0.3, 1.35 < w < 1.65, 0.44 < x < 0.54, 0.001 < y < 0.011).

4. The thermoelectric conversion element according to claim 1, wherein
the thermoelectric conversion material further contains Bi, Te and Cu and is expressed as Mg₃₊ᵥSb_{w}BiₓTe_{y}Cu_{z} (where 0.1 < v < 0.3, 1.35 < w < 1.65, 0.43 < x < 0.53, 0.001 < y < 0.011, 0.009 < z < 0.011).

5. A method for manufacturing a thermoelectric conversion element having a thermoelectric conversion layer and an electrode layer laminated on the thermoelectric conversion layer, the method comprising:
a first sintering process for sintering a thermoelectric conversion material to form a pellet;
a laminating process for forming a layer of electrode material on at least one of the two opposing sides of the pellet; and
a second sintering process for heat treating the pellet on which the layer of electrode material has been formed,
wherein the first sintering process is performed at a temperature higher than the reaction initiation temperature at which the electrode material starts to react with the thermoelectric conversion material, and the second sintering process is performed at a temperature lower than the reaction initiation temperature.

6. The method for manufacturing a thermoelectric conversion element according to claim 5, wherein
the thermoelectric conversion material contains Mg and Sb, and the electrode material contains a CuNi alloy; and
the reaction initiation temperature is the temperature at which the reaction between the Cu or / and Ni constituting the CuNi alloy and the thermoelectric conversion material begins.

7. The method for manufacturing a thermoelectric conversion element according to claim 6, wherein
the thermoelectric conversion material is Mg₃₊ᵥSb_{w}BiₓTe_{y}Cu_{z} (where 0.1 < v < 0.3, 1.35 < w < 1.65, 0.43 < x < 0.53, 0.001 < y < 0.011, 0.009 < z < 0.011).
